# EUROPÄISCHE PATENTANMELDUNG

(11) **EP 1 449 930 A1**
(43) Veröffentlichungstag der Anmeldung: **25.08.2004**
(21) Anmeldenummer: 03100378.3
(22) Anmeldetag: 19.02.2003
(51) Int. Cl.: C22C 14/00, C22C 28/00, C23C 30/00

(54) **Legierung, Verfahren zum Erzeugen von Schichten mittels einer derartigen Legierung, sowie beschichtetes Substrat**

(71) Anmelder: Sulzer Markets and Technology AG, 8401 Winterthur (CH)
(72) Erfinder: Krumeich Jorg, CH-8406 Winterthur (CH); Ernst Peter DR., CH-8174 Stabel b.Niederglatt (CH); Rossmann Sebastian, CH 8500 Frauenfeld (CH)
(74) Vertreter: Sulzer Management AG

(57) **Zusammenfassung**

Es wird eine Legierung vorgeschlagen, die als wesentliche Bestandteile Titan (Ti) und Scandium (Sc) enthält, wobei die Summe aus dem Titan-Gehalt und dem Scandium-Gehalt mindestens 50 Gewichtsprozent und vorzugsweise mindestens 80 Gewichtsprozent beträgt. Ferner wird die Erzeugung von Schichten auf einem Substrat unter Verwendung einer solchen Legierung vorgeschlagen.

## Beschreibung

Die Erfindung betrifft eine Legierung, die als einen wesentlichen Bestandteil Titan enthält, ein Verfahren zum Erzeugen von Schichten auf einem Substrat mittels einer deratigen Legierung, sowie ein beschichtetes Substrat.

Für industrielle Anwendungen wird heutzutage kontinuierlich nach neuen Materialien gesucht, die den hohen Belastungskollektiven in den unterschiedlichsten Bereichen in immer besserer Weise gewachsen sind. Die individuellen Belastungen umfassen mechanische, thermische und chemische. Solche neuen Materialien werden einerseits für die gesamthafte Herstellung von Werkstücken verwendet, andererseits strebt man danach,durch Aufbringen von Beschichtungen mit solchen Materialien auf Substraten - beispielsweise in Form von Schichten oder dünner Schichten - die Oberflächeneigenschaften gezielt zu verändern, um so die Oberfläche optimal an den jeweiligen Anwendungsfall anzupassen.

Hierbei können sehr unterschiedliche Aspekte von Bedeutung sein, z. B. die mechanischen Eigenschaften wie Härte, Festigkeit, die tribologischen Eigenschaften, Verschleisseigenschaften oder chemische Eigenschaften wie Oxidationsbeständigkeit.

Aufgabe der Erfindung ist es, ein Material vorzuschlagen, dass sehr gute mechanische Eigenschaften, insbesondere eine hohe Härte und Festigkeit, aufweist. Das Material soll ferner geeignet sein, um damit Beschichtungen in Form dünner Schichten auf einem Substrat zu erzeugen, wobei die Beschichtungen sehr gute mechanische Eigenschaften aufweisen.

Die diese Aufgabe lösenden Gegenstände der Erfindung sind durch die Merkmale der unabhängigen Ansprüchge der jeweiligen Kategorie gekennzeichnet.

Erfindungsgemäss wird also eine Legierung vorgeschlagen, die als wesentliche Bestandteile Titan (Ti) und Scandium (Sc) enthält, wobei die Summe aus dem Titan-Gehalt und dem Scandium-Gehalt mindestens 50 Gewichtsprozent und vorzugsweise mindestens 80 Gewichtsprozent beträgt.

Es hat sich gezeigt, dass eine solche Legierung eine sehr hohe Härte aufweist, einen hohen Elastizitätsmodul sowie eine hohe Festigkeit. Vorteilhaft ist an der erfindungsgemässen Legierung, dass sie eine leichte Legierung ist, dass heisst die Masse pro Volumen ist im Bereich von Leichtmetallen. Ferner zeigt die Legierung eine sehr gute Oxidationsbeständigkeit.

Ein weiterer wesentlicher Vorteil der erfindungsgemässen Legierung ist es, dass sie biokompatibel ist und somit beispielsweise in der Medizinaltechnik für die Herstellung und/oder Beschichtung von Implantaten geeignet ist.

Die Praxis hat gezeigt, dass es besonders vorteilhaft ist, wenn der Titan-Gehalt mindestens 50 Gewichtsprozent beträgt.

Hinsichtlich des Scandium-Gehalts wird es bevorzugt, wenn dieser höchstens 40 Gewichtsprozent und vorzugsweise zwischen 20 und 30 Gewichtsprozent beträgt.

Gute mechanische Eigenschaften zeigt insbesondere auch eine Legierung, welche abgesehen von üblicherweise auftretenden Verunreinigungen aus Titan und Scandium besteht, beispielsweise etwa 75% Ti und etwa 25% Sc.

Je nach Anwendungsfall und den damit verbundenen Anforderungen können der Legierung jedoch auch weitere Elemente hinzugefügt werden, um ihre Eigenschaften gezielt zu modifizieren, beispielsweise das Verschleissverhalten und/oder die Oxidationsbeständigkeit und/oder mechanische Eigenschaften. Dazu kann die Legierung z. B. eines oder mehrere der folgenden Elemente enthalten: Aluminium (Al), Niob (Nb), Tantal (Ta), Chrom (Cr), Magnesium (Mg), Yttrium (Y), Hafnium (Hf), Calcium (Ca), Lithium (Li), Bor (B), Silicium (Si) Stickstoff (N), Sauerstoff (O), Kohlenstoff (C), Zirkonium (Zr).

Erfindungsgemäss wird ferner ein Verfahren zum Erzeugen von Schichten auf einem Substrat vorgeschlagen. Dieses Verfahren ist dadurch gekennzeichnet, dass zum Erzeugen der dünnen Schicht eine erfindungsgemässe Legierung verwendet wird.

Diese Schichten zeichnen sich durch sehr hohe Härte, hohe Elastizitätsmodule, hohe Festigkeit und gute Oxidationsbeständigkeit aus. Ferner sind die erfindungsgemäss hergestellten Beschichtungen biokompatibel und eigen sich daher für den Einsatz in der Medizinaltechnik, beispielsweise auf Implantaten.

Vorzugsweise erfolgt die Erzeugung der Schicht durch thermisches Spritzen oder durch Abscheiden aus der Dampfphase, insbesondere mittels physikalischer Abscheidung (PVD), speziell mittels Sputtern. In der Praxis hat sich insbesondere das Magnetron Sputtern bewährt.

Mittels PVD, speziell mittels Sputtern, lassen sich vorzugsweise dünne Schichten erzeugen, die eine Dicke von höchstens 10 Mikrometern aufweisen. Mittels thermischen Spritzens werden typischerweise dickere Schichten im Bereich von 0,2mm bis 0,5 mm Dicke erzeugt

Zur Erzeugung der Schicht ist es möglich, die Legierung in metallischer Form auf dem Substrat abzuscheiden, sodass die Beschichtung aus der Legierung besteht.

Es ist aber auch eine solche Verfahrensführung möglich, bei welcher die Erzeugung der dünnen Schicht in einer Atmosphäre mit einem Reaktivgas erfolgt, derart, dass die dünne Schicht eine keramische Schicht ist, insbesondere ein Nitrid, ein Oxid, ein Carbid oder ein Carbonitrid der Legierung. Derartige keramische Beschichtungen zeichen sich durch eine noch höhere Härte aus. Es hat sich beispielsweise gezeigt, dass eine keramische Ti-Sc-Nitrid Beschichtung eine deutlich höhere Härte, einen deutlich höheren Elastizitätsmodul sowie eine höhere Hitzebeständigkeit hat als die heute häufig verwendete Ti-Nitrid Beschichtung.

Gemäss einer Variante des erfindungsgemässen Verfahrens wird mittels einer erfindungsgemässen Legierung ein keramisches Ausgangsmaterial hergestellt und dieses keramische Ausgangsmaterial wird zur Erzeugung der Schicht verwendet, derart, dass die Schicht eine keramische Schicht ist, insbesondere ein Nitrid, ein Oxid ein Carbid oder ein Carbonitrid der Legierung. Auch bei dieser Variante kann die Erzeugung der Schicht - beispielsweise mittels Magnetron Sputtern oder mittels thermischen Spritzens - in einer Atmosphäre mit einem Reaktivgas erfolgen

Gemäss der Erfindung wird ferner ein beschichtetes Substrat vorgeschlagen, welches mit der erfindungsgemässen Legierung beschichtet ist, oder auf dem eine Schicht vorgesehen ist, die mittels des erfindungsgemässen Verfahrens hergestellt ist.

Die Schicht kann insbesondere auch eine dünne Schicht sein. In der Praxis hat es sich bewährt, wenn die Dicke der dünnen Schicht höchstens 10 Mikrometer und vorzugsweise etwa 3-5 Mikrometer beträgt.

Weitere vorteilhafte Massnahmen und bevorzugte Ausgestaltungen der Erfindung ergeben sich aus den abhängigen Ansprüchen.

Im Folgenden wird die Erfindung an Hand von Ausführungsbeispielen näher erläutert.

Sofern dies nicht ausdrücklich anders gekennzeichnet wird, sind im Folgenden mit Angaben in Prozent stets Gewichtsprozent gemeint.

Die erfindungsgemässe Legierung enthält als wesentliche Bestandteile Titan (Ti) und Scandium (Sc), wobei die Summe aus dem Ti-Gehalt und dem Sc-Gehalt mindestens 50%, vorzugsweise mindestens 80% beträgt.

Bevorzugte Bereiche sind für den Ti-Gehalt mindestens 50% und für den Sc-Gehalt höchstens 40%, wobei der Bereich von 20% bis 30% für den Sc-Gehalt besonders bevorzugt ist. Vorzugsweise ist also der Ti-Gehalt höher als der Sc-Gehalt.

Wesentlich für die Erfindung war die Erkenntnis, dass sich durch das Hinzufügen von Scandium Ti-Legierungen herstellen lassen, welche im Vergleich zu bekannten Titanlegierungen deutlich verbesserte Eigenschaften haben. Insbesondere lassen sich hervorragende mechanische Eigenschaften auch bei höheren Einsatztemperaturen erzielen: eine sehr hohe Härte, eine hohe Festigkeit und ein hohes Elastizitätsmodul (E-Modul).

So hat es sich gezeigt, dass die erfindungsgemässe Legierung eine Härte aufweist, beispielsweise gemessen durch die Vickers-Härte, die grösser ist als die jeweilige Härte der beiden wesentlichen Legierungskomponenten Titan und Scandium.

Zudem ist die erfindungsgemässe Legierung eine leichte Legierung, womit gemeint ist, dass ihre Masse pro Volumen so gering ist, dass sie im Bereich von Leichtmetallen liegt.

Ferner hat sich gezeigt, dass die erfindungsgemässe Legierung eine gute Oxidationsbeständigkeit aufweist. Dies ist unter anderem dadurch bedingt, dass die Legierung eine Selbst-Passivierung durch Ausbildung einer Oberflächenoxidschicht erfährt.

Ein wesentlicher Vorteil der erfindungsgemässen Legierung ist darin zu sehen, dass sie biokompatibel ist und somit auch für medizinische Anwendungen wie die Herstellung von Implantaten, Knochenschrauben, -nägeln, Platten oder Werkzeugen geeignet ist.

Im Folgenden wird nun anhand eines Ausführungsbeispiels erläutert, wie eine erfindungsgemässe Legierung herstellbar ist.

In einem ersten Schritt wird die Rezeptur bzw. die stöchiometrische Zusammensetzung der herzustellenden Legierung festgelegt. Bei dem hier beschriebenen Ausführungsbeispiel werden abgesehen von üblicherweise auftretenden Verunreinigungen nur Titan und Scandium als Legierungskomponenten gewählt. Der Anteil an Scandium beträgt 25 Atomprozent, das sind etwa 23.8 Gewichtsprozent. Der Rest ist Titan.

Durch kristallines Sublimieren wird feinkristallines Sc-Pulver gewonnen, das zu Pillen gepresst wird. Die Lagerung des Scandiums erfolgt unter Argon. Die Einwaage für die Schmelze ist Titan, das als sogenannter Titan-Schwamm eingebracht wird, und Scandium-Pillen. Beide Elemente weisen eine Reinheit von mindestens 99.9% auf. Die Einwaage wird in einen Schmelztiegel aus Graphit gebracht und anschliessend unter Vakuum mit Argon-Partialdruck induktiv eingeschmolzen. Die Temperatur der Schmelze wird bis auf 1700° Celsius erhöht. In einem nächsten Schritt wird die Legierung in eine Gussform aus Kupfer gegossen, wobei die Gusstemperatur 1600° Celsius nicht unterschreiten soll. In der Gussform kühlt die Legierung dann ab. Um in der Legierung enthaltene Gasporen zu reduzieren oder ganz zu eliminieren, ist es vorteilhaft, die Legierung nochmals umzuschmelzen, das heisst, die Legierung nach ihrem Erstarren wieder vollständig zu schmelzen und erstarren zu lassen.

Bei diesem Ausführungsbeispiel besteht die Legierung abgesehen von Verunreinigungen nur aus Titan und Scandium. Es ist natürlich auch möglich, noch weitere Komponenten als Zusätze in die Legierung einzubringen.
Hierzu eignen sich insbesondere die folgenden Elemente: Aluminium (Al), Niob (Nb), Tantal (Ta), Chrom (Cr), Magnesium (Mg), Yttrium (Y), Hafnium (Hf), Calcium (Ca), Lithium (Li), Bor (B), Silicium (Si) Stickstoff (N), Sauerstoff (O), Kohlenstoff (C), Zirkonium (Zr).

Durch die Verwendung solcher Zusätze bei der Herstellung der Legierung können je nach konkretem Anwendungsfall die Eigenschaften der Legierung gezielt modifiziert und optimiert werden. So ist es beispielsweise möglich, durch Zusätze den Verschleiss der Legierung zu reduzieren oder die Härte und/oder die Oxidationsbeständigkeit noch weiter zu erhöhen. Ferner kann die Oberflächenenergie verändert werden, um so beispielsweise die Benetzbarkeit zu verändern.

Die erfindungsgemässe Legierung eignet sich zur Herstellung einer Vielzahl von Werkstücken. Aufgrund ihrer Biokompatibilität können beispielsweise Implantate, insbesondere mechanisch hoch belastete Implantate wie Prothesen, Stents, Werkzeuge für die Chirurgie oder Schrauben, Nägel und Platten für medizinaltechnische Anwendungen aus der erfindungsgemässen Legierung hergestellt werden.

Da die erfindungsgemässe Legierung sehr leicht ist eignet sie sich insbesondere auch für die Herstellung von Leichtbauelementen in vielen Zweigen der Industrie.

Neben der Produktion von Werkstücken ist die Erfindung insbesondere auch für das Erzeugen von Schichten auf einem Substrat geeignet. Dabei ist es möglich, die Legierung in metallischer Form auf das Substrat aufzubringen, sodass die Beschichtung im wesentlichen aus der Legierung besteht. Es ist aber auch möglich, und für viele Anwendungen sogar vorteilhaft, die dünne Schicht als keramische Schicht zu erzeugen, die beispielsweise aus einem Nitrid, einem Carbid, einem Carbonitrid oder einem Oxid der erfindungsgemässen Legierung besteht.

Die folgenden Erläuterungen gelten in sinngemäss gleicher Weise sowohl für die metallische als auch für die keramische Beschichtung.

Vorzugsweise wird die dünne Schicht durch ein an sich bekanntes thermisches Spritzverfahren generiert oder durch Abscheidung aus der Dampfphase. Für die Erzeugung von dünnen Schichten von höchstens 10 Mikrometern und vorzugsweise 3-5 Mikrometern ist die Abscheidung aus der Dampfphase bevorzugt, während mittels thermischen Spritzens typischerweise dickere Schichten von bis zu 5mm generiert werden.

Bei der Herstellung durch Abscheidung ist insbesondere die physikalische Abscheidung aus der Dampfphase (PVD) bevorzugt. Gemäss einer Ausführungsform des erfindungsgemässen Verfahrens erfolgt die Beschichtung durch Sputtern, speziell durch Unbalanced Magnetron Sputtern. Bei dieser an sich bekannten Vakuum-Beschichtungstechnik wird beispielsweise eine Platte, die aus einer erfindungsgemässen Legierung besteht, einem Beschuss mit Argon-lonen ausgesetzt. Die Argon-lonen werden in einem Magnetron durch Stossionisation mittels Elektronen erzeugt. Durch den Beschuss mit Argon-lonen lösen sich Teilchen aus der Platte, die einen Dampf bzw. eine Wolke bilden. Dieses Material scheidet sich dann auf dem zu beschichtenden Substat ab.

Ist die Abscheidung in Form einer keramischen Schicht gewünscht, so erfolgt die Abscheidung aus der Dampfphase in einer Atmosphäre, die ein entsprechendes Reaktivgas enthält. Soll beispielsweise eine Nitridschicht erzeugt werden, so kann Stickstoff als Reaktivgas verwendet werden.

Ferner ist es möglich, zunächst mittels der Legierung ein keramisches Ausgangsmaterial herzustellen und dieses Ausgangsmaterial dann zur Erzeugung der Schicht zu verwenden.

Die Schichtdicke auf dem Substrat ist im Falle dünner Schichten vorzugsweise höchstens 10 Mikrometer, insbesondere bevorzugt sind Schichtdicken von 3-5 Mikrometern.

Natürlich sind prinzipiell auch andere Beschichtungsverfahren zur Erzeugung der dünnen Schichten möglich, beispielsweise CVD (Chemical Vapor Deposition).

Insbesondere im Falle der keramischen Beschichtungen lassen sich noch höhere Härten erzielen als bei der Legierung an sich. Beispielsweise konnte eine dünne Schicht aus Ti-Sc-Nitrid erzeugt werden, deren Vickershärte gemessen mit 5 mN (Millinewton) etwa 5000 beträgt.

Zur Herstellung der dünnen Schichten ist sowohl eine erfindungsgemässe Legierung geeignet die ausser Verunreinigungen nur aus Ti und Sc besteht, als auch eine erfindungsgemässe Legierung die noch Zusätze als weitere Komponenten enthält. Wie bereits vorne für die Legierung erläutert, können auch die Beschichtungen durch die Zusätze in der Legierung gezielt an den jeweiligen Anwendungsfall angepasst werden.

Die erfindungsgemässen Schichten zeichnen sich durch eine sehr hohe Härte, einen hohen Elastizitätsmodul, eine hohe Festigeit, eine sehr gute Oxidationsbeständigkeit und durch ihre Biokompatibilität aus. Beispielsweise ist die Oxidationsbeständigkeit einer erfindungsgemäss erzeugten dünnen Schicht deutlich besser als bei dem heute zu diesem Zweck üblicherweise verwendeten Titan-Aluminium-Nitrid.

Vergleicht man beispielsweise eine dünne Schicht aus Ti-Sc-Nitrid mit dem heute häufig verwendeten Ti-Nitrid, so weisen die erfindungsgemässen Beschichtungen aus Ti-Sc-Nitrid eine wesentlich grössere Härte und einen höheren Elastizitätsmodul auf. Auch ist der Widerstand gegen Verschleiss und die Kratzfestigkeit deutlich höher. Ferner zeigt die erfindungsgemässe Beschichtung eine bessere Anhaftung z. B. auf Stahl, sodass eine höhere Lebensdauer der Beschichtung resultiert. Durch diese Eigenschaften eignen sich die erfindungsgemäss erzeugten Beschichtungen auch als Verschleissschutz.

Aufgrund der Biokompatibilität eignet sich die erfindungsgemäss hergestellte Beschichtung auch für medizinaltechnische Anwendungen, wie beispielsweise als Beschichtung von Implantaten oder chirurgischen Werkzeugen.

Ein weiterer Vorteil der erfindungsgemäss erzeugten Schichten bzw. dünnen Schichten, insbesondere der keramischen Schichten, ist ihr verbessertes Hochtemperaturverhalten, wodurch sie auch als Temperaturschutz, beispielsweise auf Werkzeugen, verwendet werden können.

Insbesondere die Ti-Sc-Nitrid Beschichtungen weisen ein leicht blassrosa, rötliches oder pinkes Aussehen aus, wodurch sie auch für dekorative Zwecke anwendbar sind.

## Patentansprüche

1. Legierung, die als wesentliche Bestandteile Titan (Ti) und Scandium (Sc) enthält, wobei die Summe aus dem Titan-Gehalt und dem Scandium-Gehalt mindestens 50 Gewichtsprozent und vorzugsweise mindestens 80 Gewichtsprozent beträgt.

2. Legierung nach Anspruch 1, bei welcher der Titan-Gehalt mindestens 50 Gewichtsprozent beträgt.

3. Legierung nach einem der vorangehenden Ansprüche, wobei der Scandium-Gehalt höchstens 40 Gewichtsprozent und vorzugsweise zwischen 20 und 30 Gewichtsprozent beträgt.

4. Legierung nach einem der vorangehenden Ansprüche, welche abgesehen von üblicherweise auftretenden Verunreinigungen aus Titan und Scandium besteht.

5. Legierung nach einem der Ansprüche 1 bis 4, die eines oder mehrere der folgenden Elemente enthält: Aluminium (Al), Niob (Nb), Tantal (Ta), Chrom (Cr), Magnesium (Mg), Yttrium (Y), Hafnium (Hf), Calcium (Ca), Lithium (Li), Bor (B), Silicium (Si) Stickstoff (N), Sauerstoff (O), Kohlenstoff (C), Zirkonium (Zr).

6. Verfahren zum Erzeugen von Schichten auf einem Substrat, **dadurch gekennzeichnet, dass** zum Erzeugen der Schicht eine Legierung gemäss einem der vorangehenden Ansprüche verwendet wird.

7. Verfahren nach Anspruch 6, bei welchem die Erzeugung der Schicht durch thermisches Spritzen oder durch Abscheiden aus der Dampfphase, insbesondere mittels physikalischer Abscheidung (PVD), speziell mittels Sputtern erfolgt.

8. Verfahren nach einem der Ansprüche 6 oder 7, wobei die Legierung in metallischer Form auf dem Substrat abgeschieden wird.

9. Verfahren nach Anspruch 6 oder 7, bei welchem die Erzeugung der Schicht in einer Athmosphäre mit einem Reaktivgas erfolgt, derart, dass die Schicht eine keramische Schicht ist, insbesondere ein Nitrid, ein Oxid, ein Carbid oder ein Carbonitrid der Legierung.

10. Verfahren nach einem der Ansprüche 6-9, bei welchem mittels der Legierung ein keramisches Ausgangsmaterial hergestellt wird und dieses keramische Ausgangsmaterial zur Erzeugung der Schicht verwendet wird, derart, dass die Schicht eine keramische Schicht ist, insbesondere ein Nitrid, ein Oxid, ein Carbid oder ein Carbonitrid der Legierung.

11. Beschichtetes Substrat, welches mit einer Legierung gemäss einer der Ansprüche 1-4 beschichtet ist, oder auf dem eine Schicht vorgesehen ist, die mittels eines Verfahrens gemäss einem der Ansprüche 6-10 hergestellt ist.

12. Beschichtetes Substrat nach Anspruch 11, wobei die Schicht eine dünne Schicht ist, deren Dicke höchstens 10 Mikrometer und vorzugsweise etwa 3-5 Mikrometer beträgt.
